# EUROPEAN PATENT SPECIFICATION

(11) **EP 1 626 410 B1**
(45) Date of publication and mention of the grant of the patent: **09.05.2007**
(21) Application number: 05017637.9
(22) Date of filing: 12.08.2005
(51) Int. Cl.: G11C 5/00, H05K 5/02

(54) **Heat radiating and protective device for a memory module**
Wärmestrahlendes und schützendes Gerät für ein Speichermodul
Dispositif de rayonnement de chaleur et protection pour un module de mémoire

(30) Priority: 13.08.2004 CN 200420068416; 04.02.2005 CN 200520050266
(43) Date of publication of application: 15.02.2006
(73) Proprietor: Chang, Wan-Chien, Shihlin District Taipei City 111 (TW)
(72) Inventor: Chang, Wan-Chien, Shihlin District Taipei City 111 (TW)
(74) Representative: Viering, Jentschura & Partner

(56) References cited:
- WO-A-02/058069
- US-A- 5 966 287
- US-B1- 6 353 538

## Description

### Field of the Invention:

The present invention relates to heat radiating and protective devices for memory strips, more particularly to a heat radiating and protective device for a memory strip wherein the memory strip is sandwiched by a pair of heat -radiating plates in order to prevent damage from collision impacts with other objects.

### Background of the Invention:

A heat radiating and protective device for a memory strip of the prior art comprises a pair of protective plates that sandwiches a memory strip, whereby the multitude of chips attached on the elongated strip can be protected from external impacts. The plates are made of materials of good heat conductivity, therefore having both of the effects of protection and heat dissipation.

The heat radiating and protective device for a memory strip of the prior art are combined by screws or a riveting mechanism. Since the combination in these ways is complicated, U-shaped clips are invented to simplify the assembly of the plates. For example, the memory-strip heat dissipating device disclosed by US 5 966.287 is a typical improvement. At the same time, a clip mechanism consisting of a retaining hook and a clip hole is used to combining the heat radiating plates.

However, the retaining hook used in the traditional heat radiating and protective device for a memory strip is a plate of uniform width slightly wider than the clip hole, which taking a square shape. Therefore, the combined plates are easy to fall apart. Especially, the plates secured by retaining hooks and the corresponding holes are easy to slide against each other, then eventually leaving the memory strip. In that case, the memory strip has to be detached from the plates and stuck to them again, a measure sometimes damaging the chips on the memory strip.

It is a further disadvantage that the U-shaped clip used in the traditional heat radiating and protective device for a memory strip is difficult to be taken from the plates once installed.

Further, since that the information technology is being improved and that the computing power is being increased accordingly, the temperature has become higher and higher, and the heat dissipation is more and more demanding. Substantial changes in the structure of the heat radiating plates are therefore necessary.

Therefore, it is important to further improve the heat radiating and protective device for a memory strip, for the sake of mass production and high success manufacturing rate.

### Summary of the Invention:

Accordingly, the first objective of the present invention is to provide a heat radiating and protective device for a memory strip comprises a pair of heat retaining plates sandwiching a memory strip. The opposite inner walls of the heat retaining plates further include plastic films for a cushioning the memory strip. The top edges the plates are respectively extended with a pair of retaining tongues and clip holes, for locking the heat-radiating plates. There is at least a locking projection formed on each of the retaining tongue, and the clip holes each have a two-step width. Thereby, as one locking projection is inserted into a clip hole, the narrower portion of the hole will be blocked with the hole, and the heat-radiating plates are not easy to fall apart and can be produced easily.

The secondary objective of the present invention is to provide a heat radiating and protective device for a memory strip wherein U-shaped clips respectively with two feet edge having recesses on both ends will engage with corresponding bulged pieces in the grooves on the heat retaining plates for a fastening effect.

Further, each of the feet edge of the U-shaped clips is provided with a middle bulged section, whereby the section will leave a gap between a clip and a heat radiating plate, and whereby the flat tip of a screw driver can be inserted for dismounting the U-shaped clip from the heat radiation plates.

Further, the heat radiating plates are upwardly extended with a heat radiating portion that surpasses the top edge of the memory strip for better heat dissipating effect.

It is another objective of the present invention that the heat radiating plates are upwardly extended with a heat radiating portion having a multitude of fins for increasing the contact area between the plates and the air and thereby enhancing the heat dissipation.

It is further objective of the present invention that the fins of the heat radiating portion can take different shapes, such as an elongated rectangle, a partially arced shape, and multi-layered holes.

Further, the heat radiating portion of the heat radiating plates can be extended from the plates, or it can be a separate component. When the heat radiating portion is a separate part, it can take different sizes to meet different occasions.

Meanwhile, the clip mechanism of the present invention is based on a retaining tongue with a locking projection and a clip hole. The locking projection can be formed on either of the lateral sides of the retaining tongue, or both lateral sides of the tongue can be provided with locking projections. Further, the retaining tongue can be provided with a notch to enhance its connection with the clip hole.

The various objects and advantages of the present invention will be more readily understood from the following detailed description when read in conjunction with the appended drawings.

### Brief Description of the Drawings:

Fig. 1 is a perspective view of the first preferred embodiment of the present invention as a heat radiating and protective device for a memory strip.
Fig. 2 is an exploded perspective view of the preferred embodiment in Fig. 1.
Fig 3 is a local enlarged view of the preferred embodiment in Fig. 1
Fig. 4-A and Fig. 4-B illustrate the process of combining the male and female pieces of a clipping mechanism of the preferred embodiment in Fig. 1
Fig. 4-C is a C-C cross-sectional view of Fig. 4-B.
Fig.5 illustrates the retention of a memory strip within the present invention.
Fig. 6-A to Fig. 6-D show other preferred embodiments of the present invention.
Fig. 7 is a perspective view of another preferred embodiment of the present invention wherein a pair of U-shaped clips is provided.
Fig. 8 is an exploded perspective view of the preferred embodiment in Fig. 7.

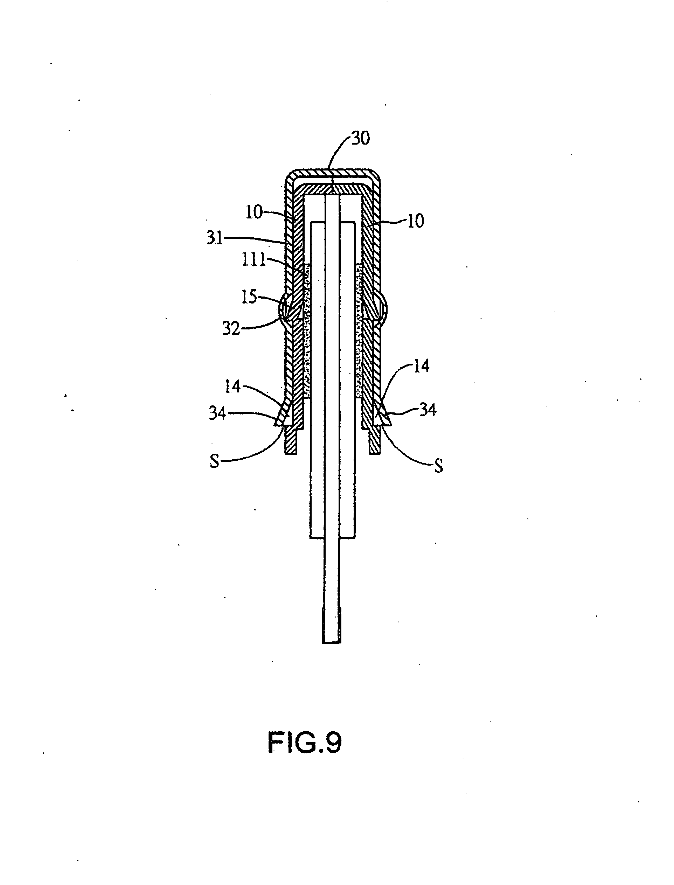

Fig. 9 is a local enlarged cross-sectional view of the preferred embodiment in Fig. 7.
Fig. 10 is an exploded perspective view of another preferred embodiment of the present invention.

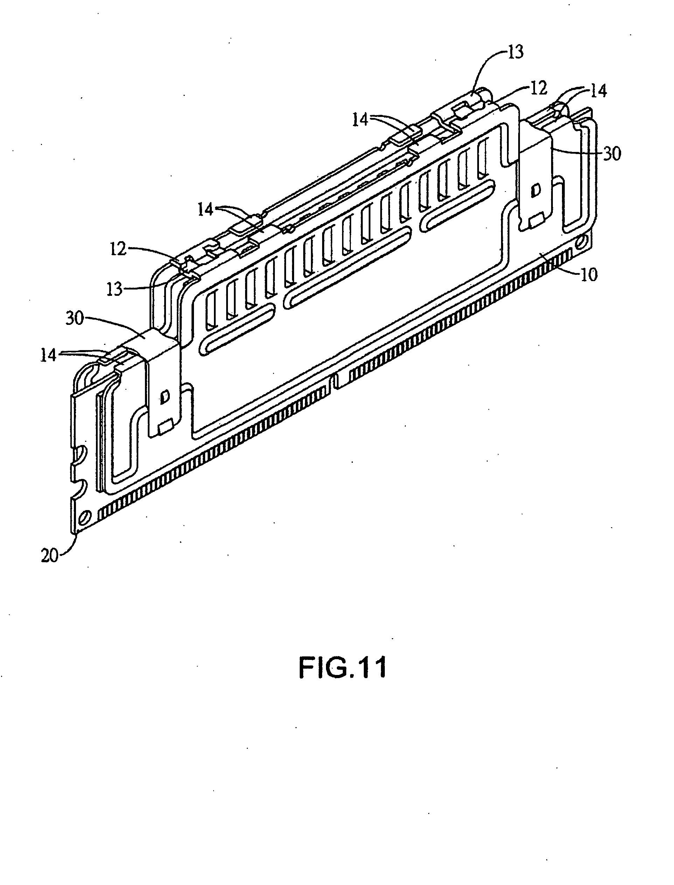

Fig. 11 is a perspective view of the preferred embodiment in Fig. 10.

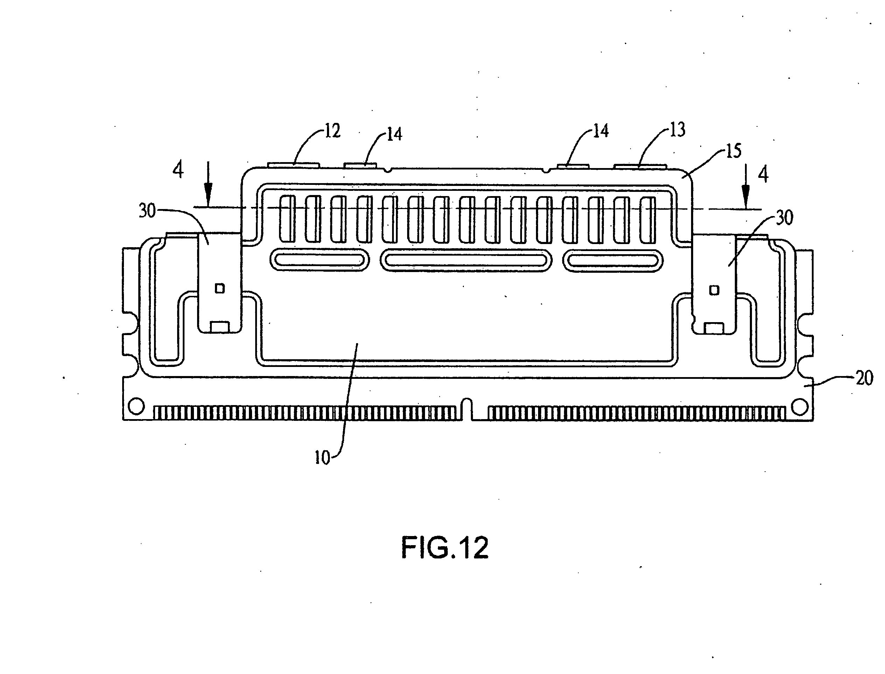

Fig. 12 is a side view of the preferred embodiment in Fig. 11.
Fig. 13 is a cross-sectional view of the preferred embodiment in Fig. 12 across the dash line 4.
Fig. 14 is a side view of another preferred embodiment of the present invention.
Fig. 14-A is a cross-sectional view of the preferred embodiment in Fig. 14 across the dash line 5A.
Fig. 15 is a side view of another preferred embodiment of the present invention.
Fig. 15-A is a cross-sectional view of the preferred embodiment in Fig. 15 across the dash line 6A.
Fig. 16 is a side view of another preferred embodiment of the present invention.
Fig. 16-A is a cross-sectional view of the preferred embodiment in Fig. 15 across the dash line 7A.
Fig. 17 is a side view of another preferred embodiment of the present invention with a detachable heat-radiating portion.
Fig. 18 is a side view of the preferred embodiment in Fig. 18 wherein the heat-radiating portion is combined with the heat-radiation plates.

### Detailed Description of the Preferred Embodiments

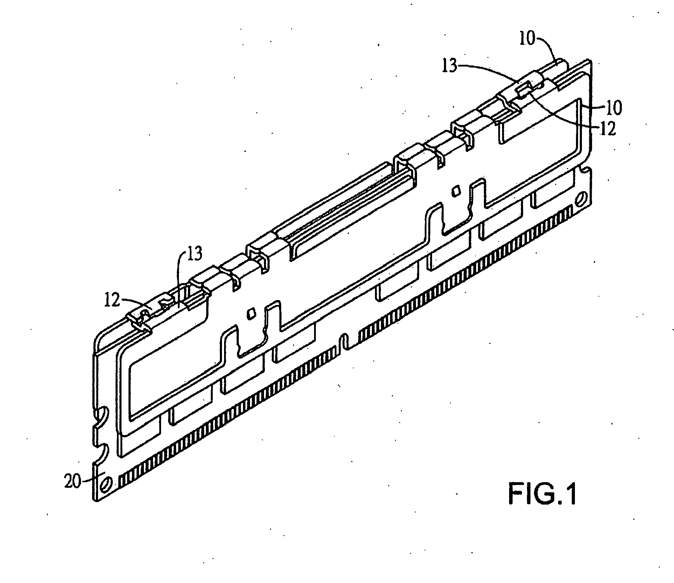

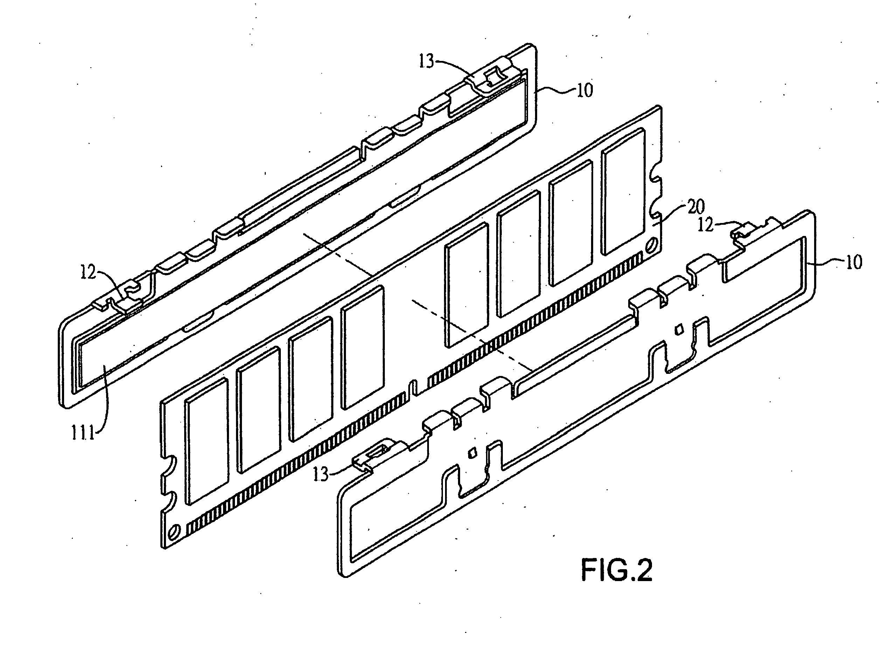

Referring to Figs. 1 and 2, a heat radiating and protective device for a memory strip according to the present invention comprises a pair of heat-radiating plates 10 sandwiching a memory strip 20 and a pair of clip mechanisms each having a male piece 12 and a female piece 13 mounted on the upper edge of the combined heat-radiating plates 10. The inner opposite walls of the heat-radiating plates 10 are respectively provided with plastic cushion films 111 for protecting the chips on the memory strip 20.

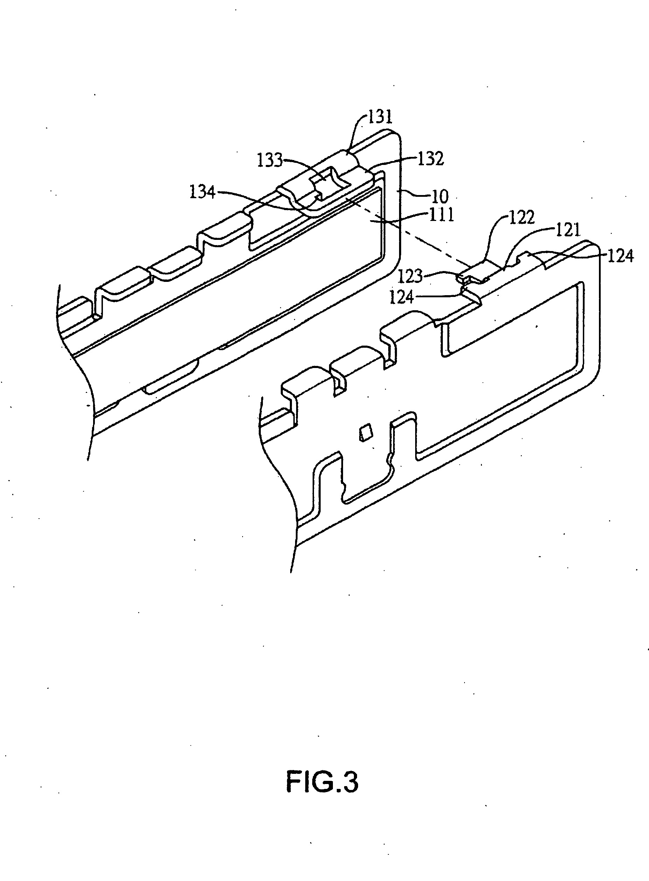

Referring to Fig. 3, the front part of each of the female pieces 13 is descended to from an engagement part 132 and the rest part forms a base 131. A clip hole is formed from the base 131 to the engagement part 132. More specifically, the portions of the clip holes on the engagement parts 132, called U-shaped lower clip holes 134, each have a width lager than that of the clip holes on the bases 131, called upper clip hole 133. Thereby, each clip hole forms a two-step clip hole.

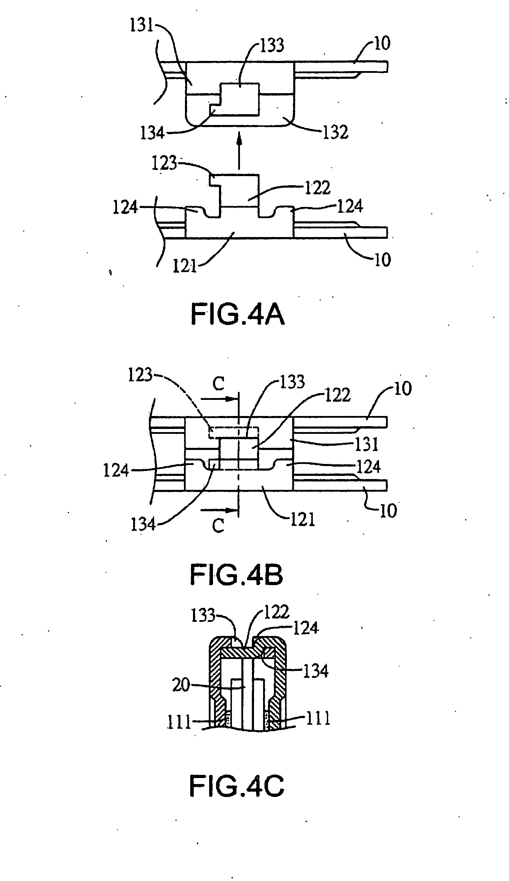

On the other hand, the front part of each of the male pieces 12 is descended to from an engagement part 122 and the rest part forms a base 121, whereby the engagement part 122 will form a retaining tongue. One lateral side of the free end of the engagement part 122 is extended with a locking projection 123 so that the width of the front edge of each of the engagement parts 122 is the same as that of the lower clip holes 134 (and therefore larger than that of the upper clip hole 133). Thereby, as the heat-radiating plates 10 are clipped, each of the engagement parts122 with the locking projections 123 will be inserted into a corresponding lower clip hole 134 and blocked by an upper clip hole 133, as shown in Figs. 4-A, 4-B and 4-C. This design is an anti-slippery one so as to retain the retaining tongues stably in the clip holes.

Further, two lateral sides of the base 121 of each of the male pieces 12 are respectively provided with retaining pieces 124 for clipping the two lateral sides of the engagement part 132 of each of the female pieces 13. Therefore, each of the retaining tongue will be secured by three points, two lateral sides and the front end.

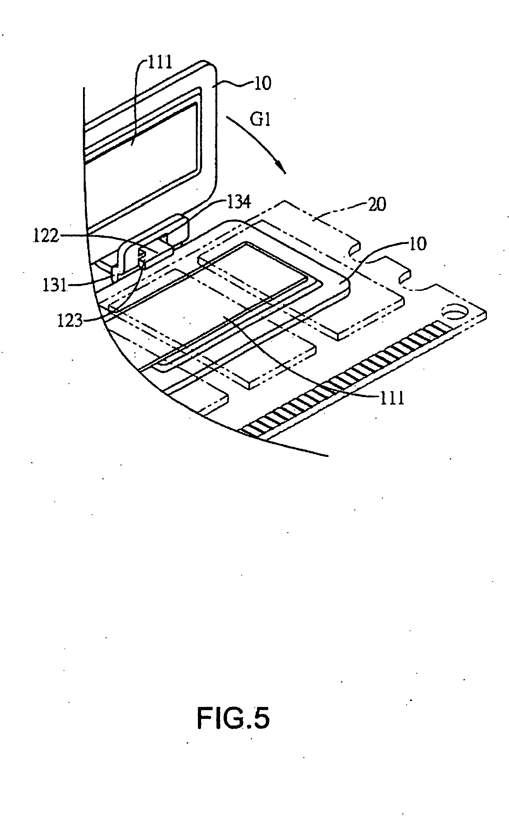

The locking projection 123 formed on the front of each of the engagement part 122 is for reinforcing the clipping of the heat-radiating plates 10. To sandwich a memory strip 20, the heat-radiating plates 10 are firstly open to receive the memory strip 20, as shown in Fig. 5. The memory strip 20 is then stuck to one of the plates. The other plate is closed toward the first plate in the G1 direction indicated, and the locking projections 123 will provide a retaining effect for precise attachment of the heat-radiating plates 10 to each other. Further, the locking projections 123 can largely reduce the possibility of reopening of the heat-radiating plates 10. Thereby, the manufacturing process can be quick and the associated cost will be low.

Specially, this design will improve the alignment of a memory strip with the heat-radiating plates, whereby the possibility of damaging a memory strip due to misaligning and detaching it again from a plate is reduced.

The location of the locking projection 123 on each of the engagement part 122 is on one lateral side thereof in this preferred embodiment. However, an engagement part 122 can be provided with a locking projection 123 on either of the lateral sides, or both of the lateral sides are provided with respective locking projections 123.

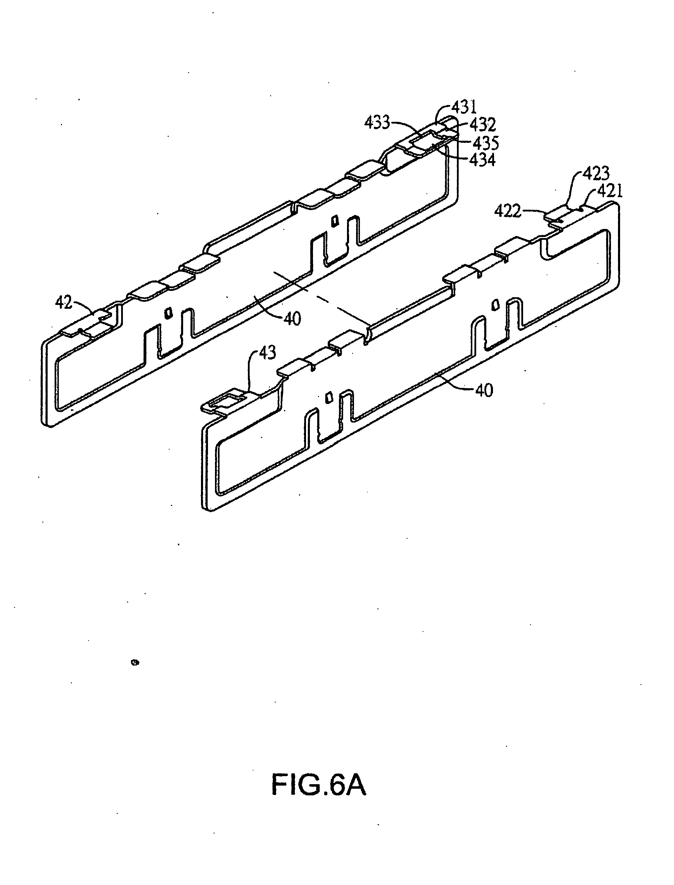

Referring to Fig. 6-A, another preferred embodiment of the present invention as a heat radiating and protective device for a memory strip has a slightly different arrangement of the male pieces 42 and the female pieces 43 of the clip mechanisms along the heat-radiating plates 40. As usual, the male pieces 42 and the female pieces 43 are each separated into a base 431 and an engagement part 432, and the clip hole is separated into an upper clip hole 433 and a lower clip hole 434. However, there is a semi-circular hole 435 formed on a lateral side of the lower clip hole 434, which is wider than the upper clip hole 433. The diameter of the semi-circular hole 435 is slightly larger than the thickness of the male piece 42. which consists of an upper section 421 and a lower section 422; the lower section 422 forms a retaining tongue. A semi-circular locking projection 423 is extended from the lateral side, near the front end, of each of the lower section 422. This design will improve the strength of clipping after the locking projections 423 are respectively inserted into corresponding semi-circular holes 435.

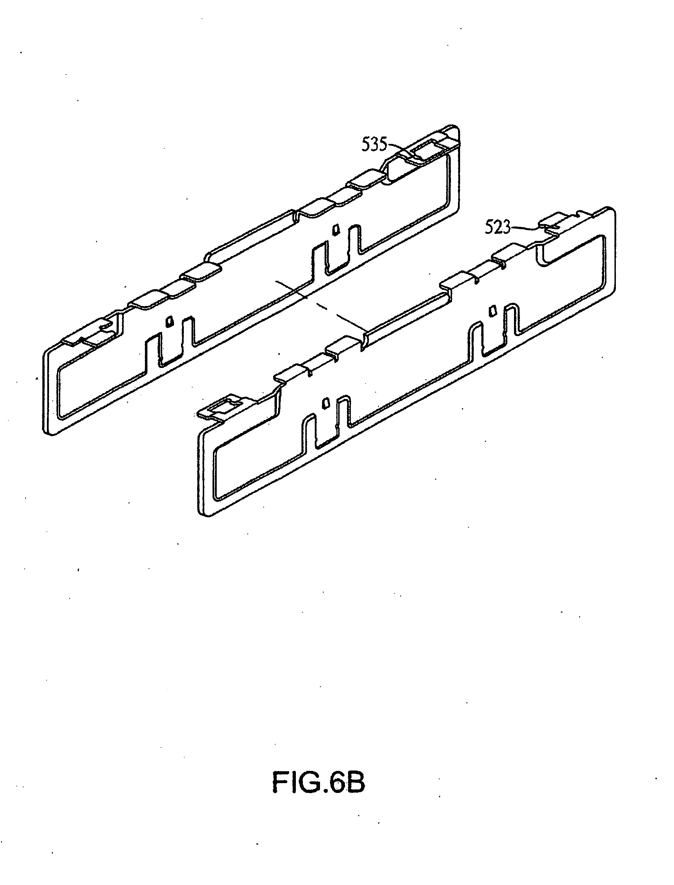

Referring to Fig. 6-B, the third preferred embodiment is similar to the previous preferred embodiment, except that the locking projections 423 are formed on the opposite lateral sides.

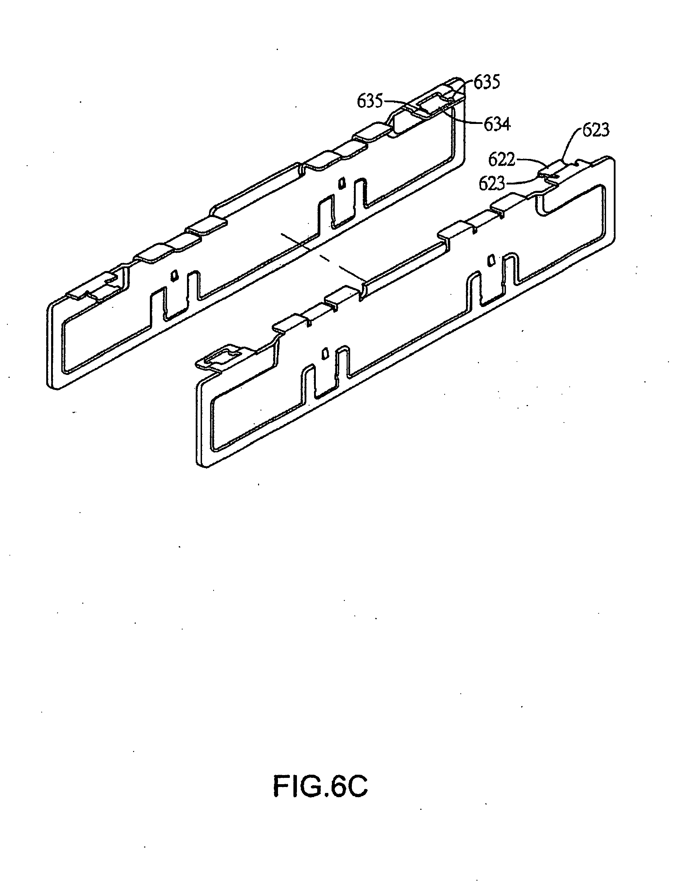

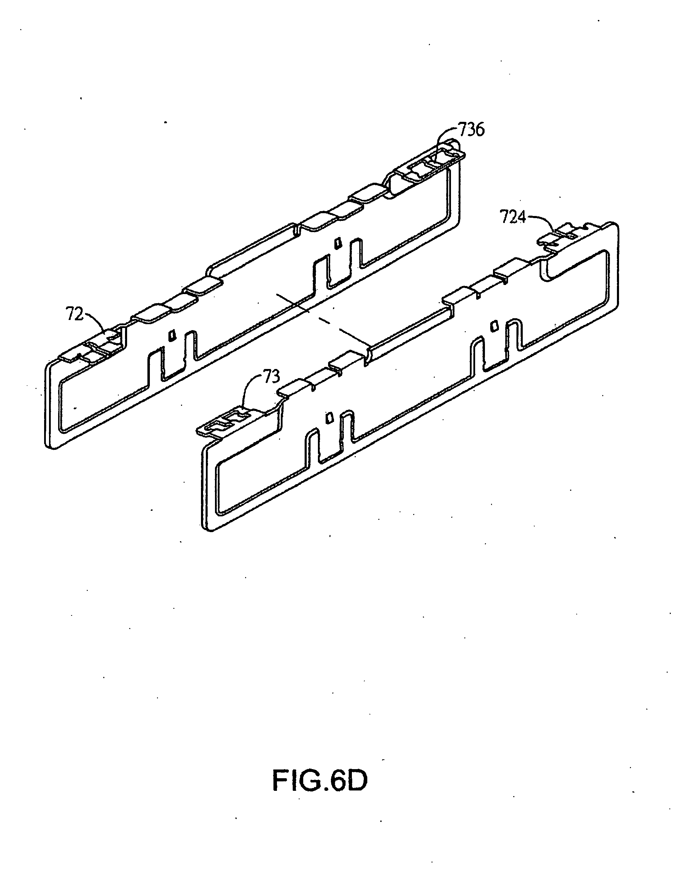

As shown in Fig. 6-c, both of the lateral sides of the engagement tongues 622 are provided with locking projections 623. Accordingly, both of the lateral sides of the clip holes on the female pieces 634 are provided with semi-circular holes 635 for facilitating the insertion of the engagement tongues 622 into the clip holes on the female pieces 634 and retaining the engagement tongues 622 more stably.

Referring to Fig. 6-C, the male piece of the clip mechanism 72 is further provided with a middle notch 724, and the clip hole of the female piece 72 is provided with a guide plate 736 slightly narrower than the notch 724, whereby the insertion of the retaining tongue of the male piece 72 into the clip hole will be assisted.

The heat radiating plates 10 of the present invention are mainly for protecting the chips on a memory strip from external impacts. Therefore, if the heat radiating plates 10 consist of a metallic and heat-conducting material and a plastic cushioning material, they can provide both of an effect of anti-shock protection and an effect of heat radiation.

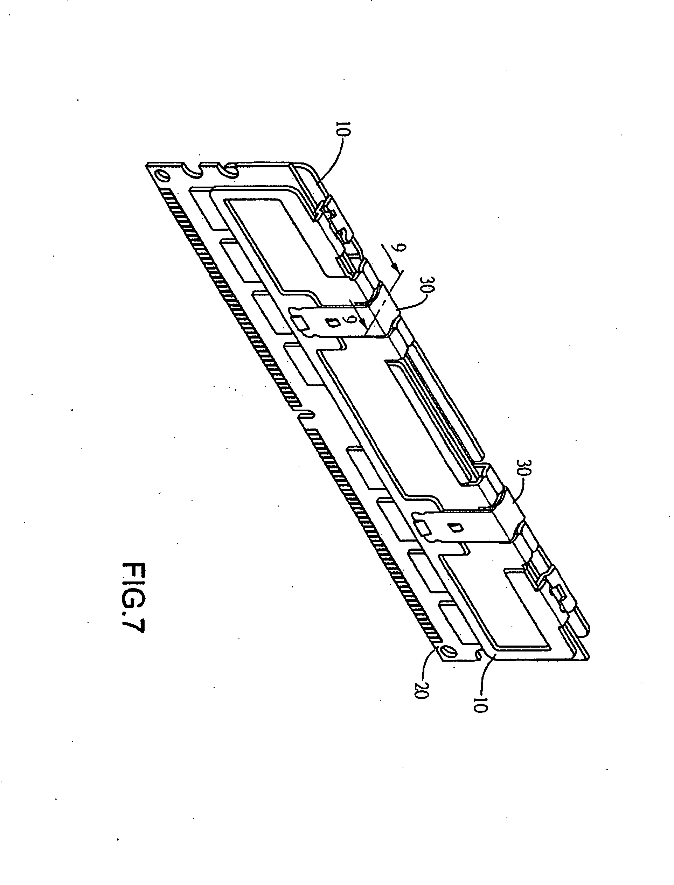

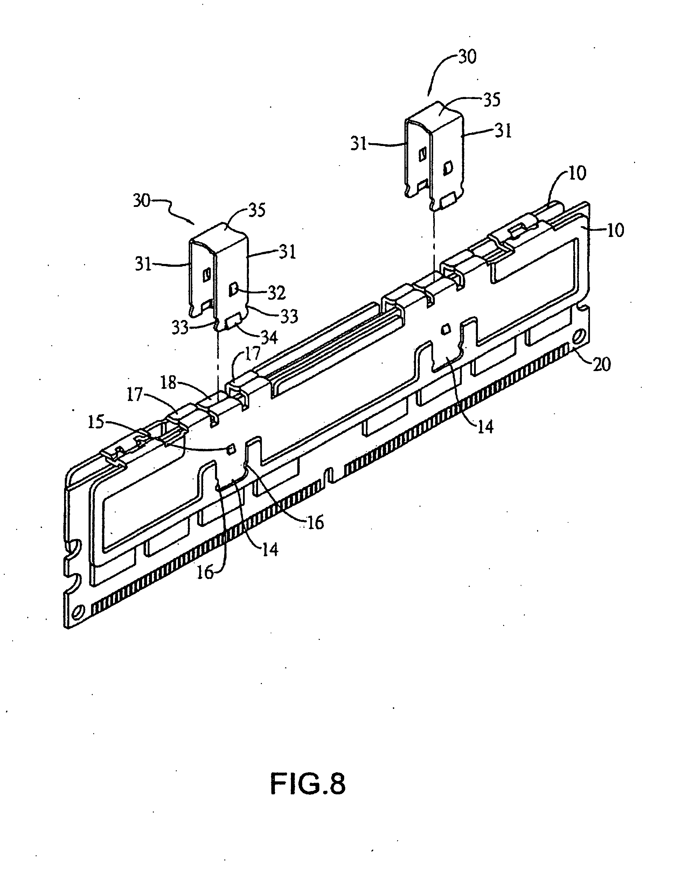

Referring to Figs. 7 and 8, the heat radiating plates 10 are further provided with a pair of U-shaped clips 30. The feet 31 of the U-shaped clips 30 confine the heat radiating plates 10 by attaching on their outer walls. A groove 14 taking the shape of a foot 31 of each of the U-shaped clips 30 is formed on the outer wall of a corresponding heat radiating plate 10, whereby the U-shaped clips 30 will not slide on the heat radiating plates 10. Further, there are receiving structures formed within the grooves 14 for retaining the U-shaped clips 30.

Referring to Fig. 8, the grooves 14 on the heat retaining plates 10 are respectively provided with point projections 15 by punching, whereas the corresponding locations on the feet 31 of the U-shaped clips 30 are provided with point depressions 32, The point projections 15 have two benefits: guiding the U-shaped clips 30 to enter the heat-radiating plates 10 and enhancing the engagement between the U-shaped clips 30 and the heat-radiating plates 10.

The other feature of the present invention is that U-shaped clips 30 respectively with two feet edge having recesses 33 on both ends will engage with corresponding bulged pieces 16 in the grooves 14 on the heat retaining plates 10 for a fastening effect.

Further, each of the feet edge of the U-shaped clips 30 is provided with a middle bulged section 34, whereby the section 34 will leave a gap S between a clip and the groove 14 of a heat radiating plate, and whereby the flat tip of a screw driver can be inserted for dismounting the U-shaped clip 30 from the heat radiation plates 10.

The connecting section 35 between two feet 31 of each of the U-shaped clips 30 is provided with a depressed toward the retaining plate18 on two bases of a clip mechanism, whereby the downward distance the U-shaped clips may extend is restricted.

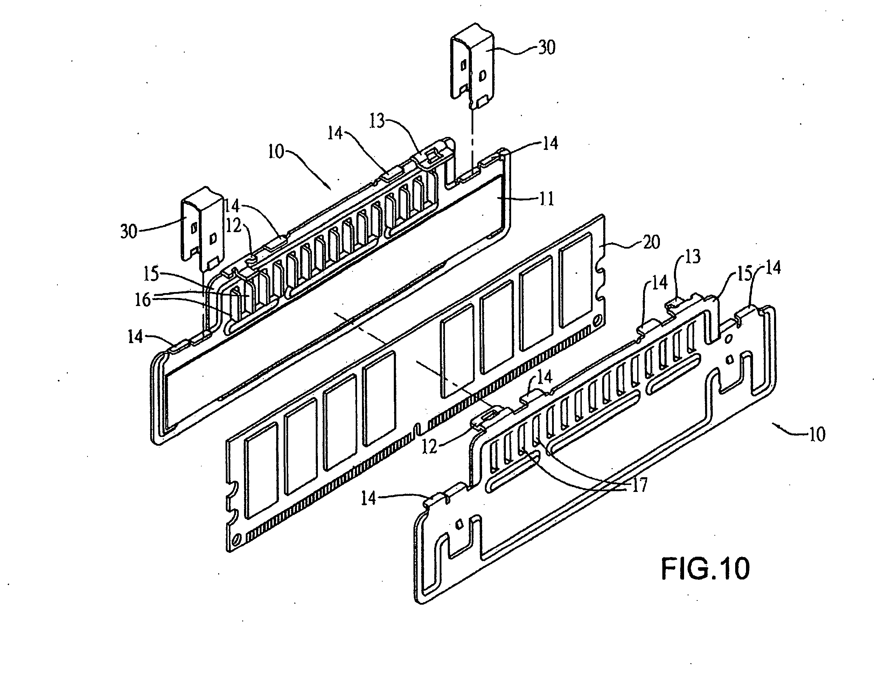

Referring to Fig. 10, the heat-radiating plates are extended upwardly passing the memory strip to form a heat-radiating portion 85, which further includes a multitude of fins 86 for enhancing the effect of heat dissipation.

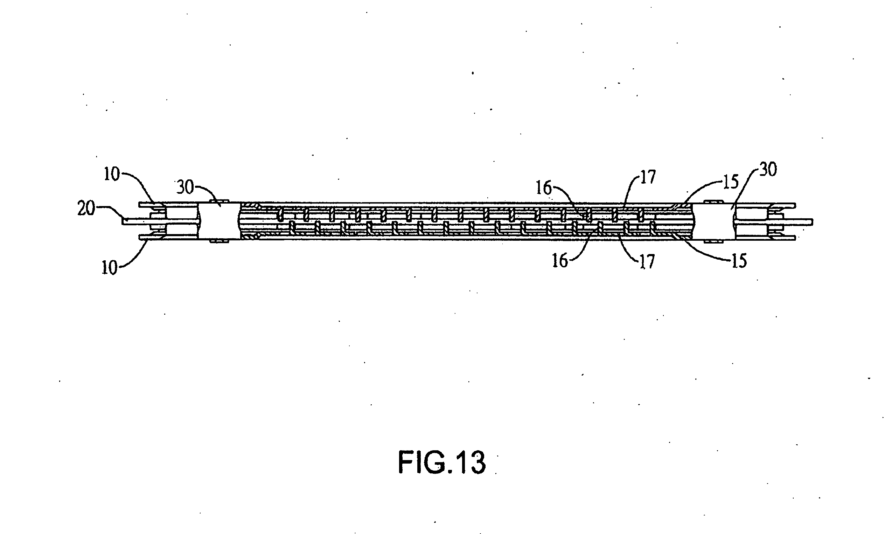

As shown in Fig. 10, the fins 86 on the heat-radiating portion 85 take a rectangular shape and are formed by punching. Meanwhile, the fins 86 leave holes 87 on the heat-radiating portion 85. Referring to Fig. 13, the fins 86 on the heat-radiating portion 85 are illustrated, which will enhance the heat exchange between the heat-radiating portion 85 and the air.

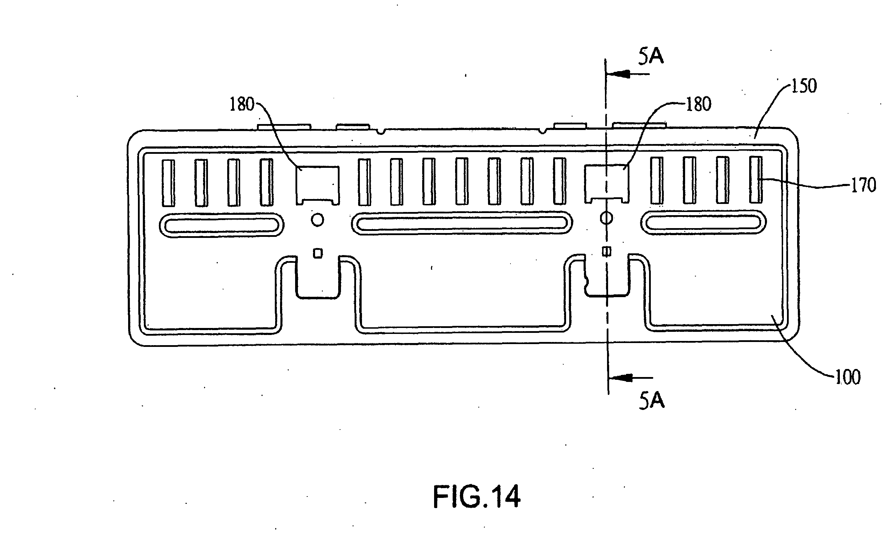

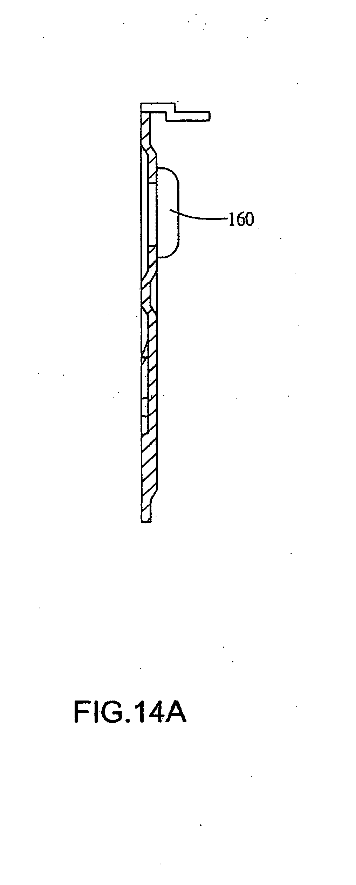

Referring to Figs. 14 and 14-A, the heat-radiating portion 850 of the present invention is extended above the heat-radiating plates 100 and forms a part of the plates. The heat-radiating portion 850 is provided with a pair of square holes 180 for the insertion of the U-shaped clips. Further, the heat-radiating portion 850 is provided with a row of fins 160 and the associated openings 170 so as to increase contact area between the heat-radiating portion 850 and the air.

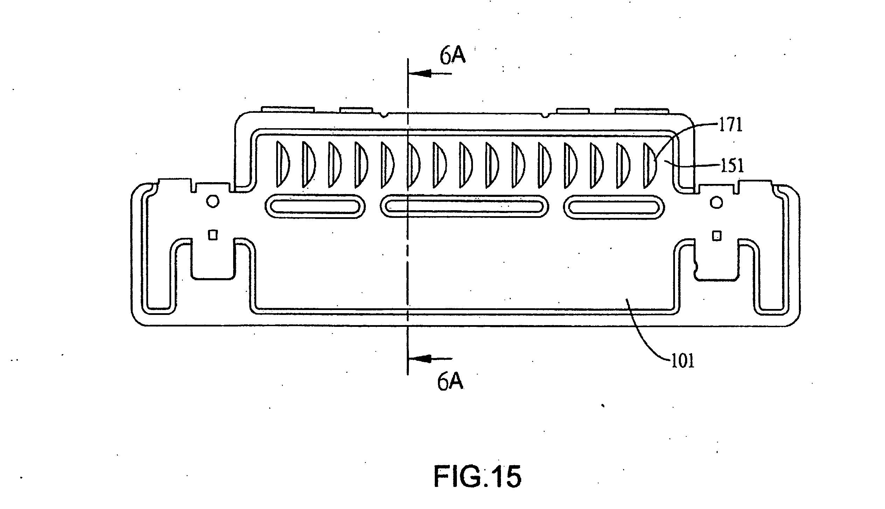

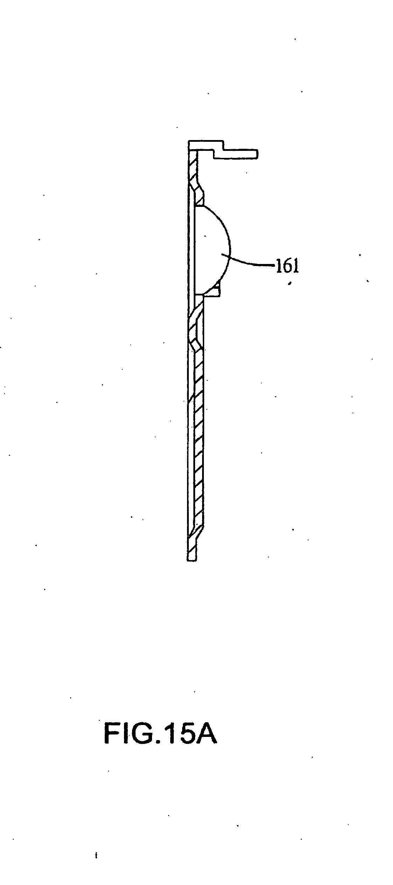

Referring to Figs. 15 and 15-A, the fins 161 and the associated openings 171 respectively take arced shapes for smoothening the air streamlines and making the heat dissipation more efficient.

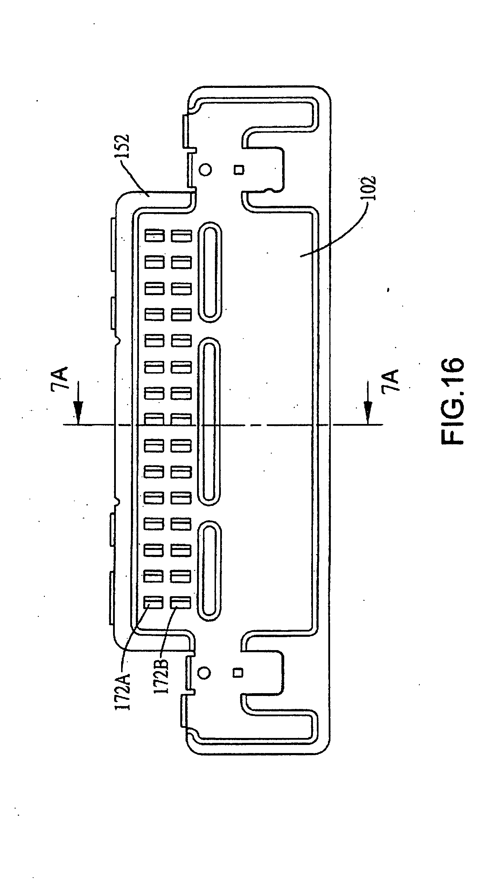

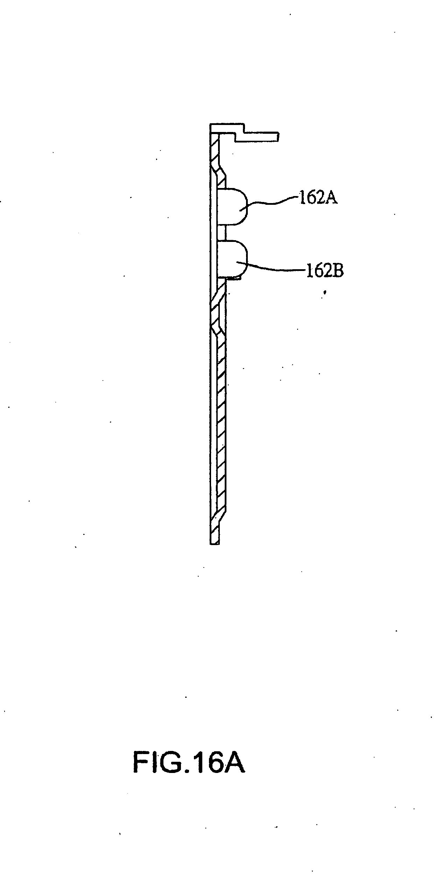

Referring to Figs. 16 and 16-A, the fins 172A and the associated openings 172B on the heat-radiating portion 852 are separated into two rows 162A and 162 B. It is of course that the number of rows for fins and openings can be more than two, or they can be even more distributed.

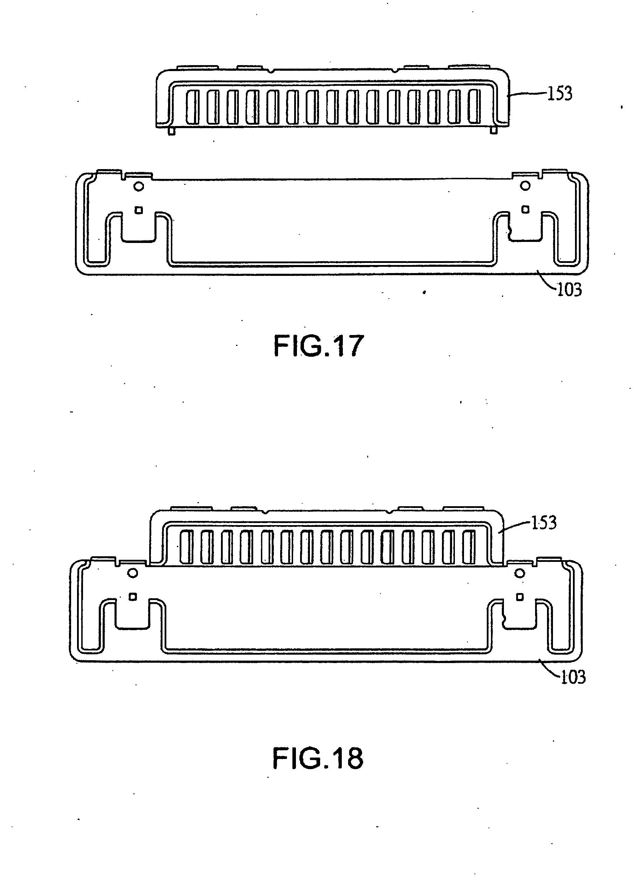

Further, referring to Figs. 17 and 18, the heat-radiating plates 103 and the heat-radiating portion 853 are designed detachable. The heat-radiating portion 853 can be attached onto the heat-radiating plates 103 by welding or riveting. This design is beneficial in that heat-radiating portions of different sizes can be chosen for different occasions.

It should be noted that in the present invention, the plastics used in above mentioned structure can be replaced by other materials. For example, said film is selected from one of plastics, foaming material or silicide material. This also within the scope of the present invention.

The present invention is thus described, and it will be obvious that the same may be varied in many ways. Such variations are not to be regarded as a departure from the spirit and scope of the present invention, and all such modifications as would be obvious to one skilled in the art are intended to be included within the scope of the following claims.

## Claims

1. A heat radiating and protective device for a memory strip, comprising:
a pair of opposite facing heat-radiating plates for sandwiching a memory strip, each of said heat-radiating plates being further provided with at least a film; and
a pair of clip mechanisms each having a female piece extended from top edges of said heat-radiating plates toward each other, each of said female pieces descending inwardly to form a two-step structure, a clip hole be formed along each of said female pieces, **characterized in that** the pair of clip mechanims each has a male piece, each of said male pieces descending inwardly, to form a two-step structure, a lower section of each of said two-step structures forming a retaining tongue for engaging with one of said clip hole of one of said female pieces, each of said retaining tongues having a front edge provided with a lateral locking projection, each of lower sections of said female pieces having a width equal to said front edges with said locking projections of said retaining tongues, whereby each of said retaining tongues will have their said front edges with said locking projections to be blocked by upper sections of said clip holes;
whereby said heat-radiating plates are adapted to be combined to settle said memory strip.

2. The heat radiating and protective device for a memory strip of claim 1 wherein said lower sections of said clip holes are respectively provided with lateral semi-circular or U-shaped holes having a curvature of radius greater than the thickness of said retaining tongues.

3. The heat radiating and protective device for a memory strip of claim 2 wherein said locking projections take a shape selected from a semi-circle and a U-shape.

4. The heat radiating and protective device for a memory strip of claim 3 wherein both lateral sides of each of said retaining tongues are provided with locking projections, and both lateral sides of each of said lower sections of said clip holes are provided with semi-circular holes.

5. The heat radiating and protective device for a memory strip of claim 4
wherein each of said retaining tongues is provided with a middle notch, and each of said clip holes respectively on said female pieces forming a small guide plate slightly narrower the width of said middle notch.

6. The heat radiating and protective device for a memory strip of claim 1 wherein said heat-radiating plates are made of a material of high thermal conductivity.

7. The heat radiating and protective device for a memory strip of claim 1 further including at least a U-shaped clip having two flexible feet clipping outer walls of said combined heat-radiating plates.

8. The heat radiating and protective device for a memory strip of claim 7 wherein the positions on said heat-radiating plates on which said feet of said U-shaped clip are attached are respectively provided with grooves for a better engagement between said U-shaped clip and said heat-radiating plates.

9. The heat radiating and protective device for a memory strip of claim 8 wherein a point projection is formed by punching on each of said heat-radiating plates, and a point depression is formed by punching on an inner wall of each of said feet of said U-shaped clip, thereby enhancing the engagement between said U-shaped clip and said heat-radiating plates.

10. The heat radiating and protective device for a memory strip of claim 7 wherein both of the lateral sides close to each of lower edges of said feet of said U-shaped clip are provided with an inwardly converging recesses, and a pair of corresponding bulged pieces are formed within each of said grooves on said heat-radiating plates, for enhancing the engagement between said U-shaped clip and said heat-radiating plates.

11. The heat radiating and protective device for a memory strip of claim 7 wherein lowest edges of said feet of said U-shaped clip are respectively provided with middle bulged sections for forming gaps between said U-shaped clip and said heat-radiating plates.

12. The heat radiating and protective device for a memory strip of claim 1 wherein a heat radiating portion is extended from an upper edge of said combined heat-radiating plates and also surpassing above said memory strip.

13. The heat radiating and protective device for a memory strip of claim 12 wherein said heat radiating portion further includes mutually engaging female and male pieces.

14. The heat radiating and protective device for a memory strip of claim 12 wherein said heat radiating portion further includes bulged plates to protect said engaged female and male pieces from falling apart.

15. The heat radiating and protective device for a memory strip of claim 12 wherein said heat-radiating plates are further secured by a pair of clips.

16. The heat radiating and protective device for a memory strip of claim 1 or 12 wherein said films attached on said inner walls of said heat-radiating plates are also attached onto said memory strip and made of a cushioning and high heat-conducting material.

17. The heat radiating and protective device for a memory strip of claim 12 wherein said heat radiating portion is provided with a multitude of fins for enlarging the contact area between said heat-radiating plates and the air.

18. The heat radiating and protective device for a memory strip of claim 17 wherein said fins on said heat radiating portion is formed by punching and form through holes thereon in pairs.

19. The heat radiating and protective device for a memory strip of claim 17 wherein said fins take the shape selected from an elongated rectangle and a semi-arced shape; said fins being arranged in rows.

20. The heat radiating and protective device for a memory strip of claim 12 wherein said heat radiating portion is an upward extended part of said heat-radiating plates; square holes being formed between said heat radiating portion and said heat-radiating plates for the insertion of said clips.

21. The heat radiating and protective device for a memory strip of claim 12 wherein said heat radiating portion is a detachable component from said heat-radiating plates.

22. The heat radiating and protective device for a memory strip of claim 16 wherein said film is selected from one of plastics, foaming material or silicide material.

## Patentansprüche

1. Wärmeabstrahlungs-und-Schutzvorrichtung für einen Speicherstreifen, aufweisend:
ein Paar von gegenseitig zugewandten Wärmeabstrahlungsplatten zum sandwichartigen Aufnehmen eines Speicherstreifens, wobei jede der Wärmeabstrahlungsplatten zusätzlich mit wenigstens einem Film versehen ist, und
ein Paar von Clipmechanismen, die jeweils ein Aufnahmeteil aufweisen, die sich von oberen Rändern der Wärmeabstrahlungsplatten in Richtung zueinander hin erstrecken, wobei jedes der Aufnahmeteile einwärts so nach unten abfällt, dass es eine Zweistufenstruktur bildet, und wobei entlang jedes der Aufnahmeteile ein Cliploch ausgebildet ist,
**dadurch gekennzeichnet, dass** das Paar von Clipmechanismen jeweils ein Einsetzteil aufweist, wobei jedes der Einsetzteile einwärts so nach unten abfällt, dass es eine Zweistufenstruktur bildet, wobei ein unterer Abschnitt jeder der Zweistufenstrukturen eine Haltezunge formt zum Ineingriffbringen mit dem Cliploch von einem der Aufnahmeteile, wobei jede der Haltezungen einen vorderen Rand aufweist, der mit einem seitlichen Verriegelungsvorsprung versehen ist, wobei jeder der unteren Abschnitte der Aufnahmeteile eine Weite aufweist, die gleich den die Verriegelungsvorsprünge aufweisenden vorderen Rändern der Haltezungen ist, wobei die jeweiligen Haltezungen ihre die Verriegelungsvorsprünge aufweisenden vorderen Ränder von oberen Abschnitten der Cliplöcher blockiert haben werden, und wobei die Wärmeabstrahlungsplatten angepasst sind, so dass sie zum Platzieren des Speicherstreifens zusammensetzbar sind.

2. Wärmeabstrahlungs-und-Schutzvorrichtung für einen Speicherstreifen gemäß Anspruch 1, wobei die unteren Abschnitte der Cliplöcher jeweils mit seitlichen, halbkreisförmigen oder U-förmigen Löchern versehen sind, die eine Radiuskrümmung aufweisen, die größer als die Dicke der Haltezungen ist.

3. Wärmeabstrahlungs-und-Schutzvorrichtung für einen Speicherstreifen gemäß Anspruch 2, wobei die Verriegelungsvorsprünge eine Form aufweisen, die aus einem Halbkreis und einer U-Form ausgewählt ist.

4. Wärmeabstrahlungs-und-Schutzvorrichtung für einen Speicherstreifen gemäß Anspruch 3, wobei beide seitlichen Seiten von jeder der Haltezungen mit Verriegelungsvorsprüngen versehen sind, und wobei beide seitliche Seiten von jedem der unteren Abschnitte der Cliplöcher mit halbkreisförmigen Löchern versehen sind.

5. Wärmeabstrahlungs-und-Schutzvorrichtung für einen Speicherstreifen gemäß Anspruch 4, wobei jede der Haltezungen mit einer Mittelaussparung versehen ist, und wobei jedes der Cliplöcher jeweils an den Aufnahmeteilen eine schmale Führungsplatte formt, die geringfügig enger als die Weite der Mittelaussparung ist.

6. Wärmeabstrahlungs-und-Schutzvorrichtung für einen Speicherstreifen gemäß Anspruch 1, wobei die Wärmeabstrahlungsplatten aus einem Material mit hoher Wärmeleitfähigkeit hergestellt sind.

7. Wärmeabstrahlungs-und-Schutzvorrichtung für einen Speicherstreifen gemäß Anspruch 1, ferner wenigstens einen U-förmigen Clip aufweisend, der zwei flexible Füße aufweist, die Außenwände der zusammengesetzten Wärmeabstrahlungsplatten umklammern.

8. Wärmeabstrahlungs-und-Schutzvorrichtung für einen Speicherstreifen gemäß Anspruch 7, wobei die Positionen an den Wärmeabstrahlungsplatten, an die die Füße des U-förmigen Clips angelegt sind, jeweils mit Nuten versehen sind für einen besseren Eingriff zwischen dem U-förmigen Clip und den Wärmeabstrahlungsplatten.

9. Wärmeabstrahlungs-und-Schutzvorrichtung für einen Speicherstreifen gemäß Anspruch 8, wobei mittels Stanzens ein Punktvorsprung an jeder der Wärmeabstrahlungsplatten geformt ist, und wobei mittels Stanzens eine Punktvertiefung an einer Innenwand von jedem der Füße des U-förmigen Clips geformt ist, wodurch der Eingriff zwischen dem U-förmigen Clip und den Wärmeabstrahlungsplatten verbessert ist.

10. Wärmeabstrahlungs-und-Schutzvorrichtung für einen Speicherstreifen gemäß Anspruch 7, wobei beide der seitlichen Seiten in der Nähe von jedem der unteren Ränder der Füße des U-förmigen Clips mit einer einwärts konvergierenden Ausnehmungen versehen sind, und wobei ein Paar von korrespondierenden, erhabenen Teilen in jeder der Nuten an den Wärmeabstrahlungsplatten geformt sind zum Verbessern des Eingriffs zwischen dem U-förmigen Clip und den Wärmeabstrahlungsplatten.

11. Wärmeabstrahlungs-und-Schutzvorrichtung für einen Speicherstreifen gemäß Anspruch 7, wobei die untersten Ränder der Füße des U-förmigen Clips mit jeweiligen Mittelausbauchungsabschnitten versehen sind zum Formen von Spalten zwischen dem U-förmigen Clip und den Wärmeabstrahlungsplatten.

12. Wärmeabstrahlungs-und-Schutzvorrichtung für einen Speicherstreifen gemäß Anspruch 1, wobei sich ein Wärmeabstrahlungsabschnitt von einem oberen Rand der zusammengesetzten Wärmeabstrahlungsplatten erstreckt und ferner über den Speicherstreifen hinausgeht.

13. Wärmeabstrahlungs-und-Schutzvorrichtung für einen Speicherstreifen gemäß Anspruch 12, wobei der Wärmeabstrahlungsabschnitt ferner miteinander in Eingriff befindliche Aufnahme- und Einsetzteile aufweist.

14. Wärmeabstrahlungs-und-Schutzvorrichtung für einen Speicherstreifen gemäß Anspruch 12, wobei der Wärmeabstrahlungsabschnitt ferner erhabene Platten aufweist zum Schützen der in Eingriff befindlichen Aufnahme- und Einsetzteile gegen ein Auseinanderfallen.

15. Wärmeabstrahlungs-und-Schutzvorrichtung für einen Speicherstreifen gemäß Anspruch 12, wobei die Wärmeabstrahlungsplatten zusätzlich mittels eines Paars von Clips gesichert sind.

16. Wärmeabstrahlungs-und-Schutzvorrichtung für einen Speicherstreifen gemäß Anspruch 1 oder 12, wobei die Filme, die an den Innenwänden der Wärmeabstrahlungsplatten angebracht sind, ferner an dem Speicherstreifen angebracht sind und aus einem dämpfenden und hochwärmeleitenden Material hergestellt sind.

17. Wärmeabstrahlungs-und-Schutzvorrichtung für einen Speicherstreifen gemäß Anspruch 12, wobei der Wärmeabstrahlungsabschnitt mit einer Vielzahl von Rippen versehen ist zum Vergrößern der Kontaktfläche zwischen den Wärmeabstrahlungsplatten und der Luft.

18. Wärmeabstrahlungs-und-Schutzvorrichtung für einen Speicherstreifen gemäß Anspruch 17, wobei die Rippen an dem Wärmeabstrahlungsabschnitt mittels Stanzens geformt sind und daran in Paaren Durchgangslöcher formen.

19. Wärmeabstrahlungs-und-Schutzvorrichtung für einen Speicherstreifen gemäß Anspruch 17, wobei die Rippen die Form aufweisen, die aus einem länglichen Rechteck und einer Halbbogenform ausgewählt ist, und wobei die Rippen in Reihen angeordnet sind.

20. Wärmeabstrahlungs-und-Schutzvorrichtung für einen Speicherstreifen gemäß Anspruch 12, wobei der Wärmeabstrahlungsabschnitt ein nach oben verlängerter Teil der Wärmeabstrahlungsplatten ist, und wobei zum Einsetzen der Clips zwischen dem Wärmeabstrahlungsabschnitt und den Wärmeabstrahlungsplatten viereckige Löcher ausgebildet sind.

21. Wärmeabstrahlungs-und-Schutzvorrichtung für einen Speicherstreifen gemäß Anspruch 12, wobei der Wärmeabstrahlungsabschnitt eine von den Wärmeabstrahlungsplatten demontierbare Komponente ist.

22. Wärmeabstrahlungs-und-Schutzvorrichtung für einen Speicherstreifen gemäß Anspruch 16, wobei der Film von einem von Kunststoffen, Schaummaterial oder Silicidmaterial ausgewählt ist.

## Revendications

1. Dispositif de rayonnement de chaleur et de protection pour une barrette de mémoire comprenant :
une paire de plaques de rayonnement de chaleur se faisant face pour prendre en sandwich une barrette de mémoire, chacune desdites plaques de rayonnement de chaleur étant en outre munie d'au moins une couche ; et
une paire de mécanismes d'agrafe ayant chacun une pièce femelle partant des bords supérieurs desdites plaques de rayonnement de chaleur en direction l'une de l'autre, chacune desdites pièces femelles descendant vers l'intérieur pour former une structure à deux étages, un orifice d'agrafe étant formé le long de chacune desdites pièces femelles **caractérisé en ce que** la paire de mécanismes d'agrafe possède chacun une pièce mâle, chacune desdites pièces mâles descendant vers l'intérieur pour former une structure à deux étages, une section inférieure de chacune desdites structures à deux étages formant une languette de retenue destinée à s'engager avec un desdits orifices de l'une desdites pièces femelles, chacune desdites languettes de retenue ayant un bord avant muni d'une saillie latérale de verrouillage, chacune des sections inférieures desdites pièces femelles ayant une largeur égale auxdits bords avant avec lesdites saillies de verrouillage desdites languettes de retenue, ce qui fait que chacune desdites languettes de retenue aura son bord avant avec ladite saillie bloquée par les sections supérieures desdits orifices d'agrafe;
ce qui fait que lesdites plaques de rayonnement de chaleur sont adaptées pour se combiner afin de s'installer sur ladite barrette de mémoire.

2. Dispositif de rayonnement de chaleur et de protection pour une barrette de mémoire selon la revendication 1, dans lequel lesdites sections inférieures desdits orifices d'agrafe sont respectivement prévues avec des orifices latéraux semi-circulaires ou en forme de U ayant une courbure de rayon supérieure à l'épaisseur desdites languettes de retenue.

3. Dispositif de rayonnement de chaleur et de protection pour une barrette de mémoire selon la revendication 2, dans lequel lesdites saillies de verrouillage prennent une forme choisie parmi un demi-cercle et une forme en U.

4. Dispositif de rayonnement de chaleur et de protection pour une barrette de mémoire selon la revendication 3, dans lequel les deux côtés latéraux de chacune desdites languettes de retenue sont munis de saillies de verrouillage, et les deux côtés latéraux de chacune desdites sections inférieures desdits orifices d'agrafe sont munis d'orifices semi-circulaires.

5. Dispositif de rayonnement de chaleur et de protection pour une barrette de mémoire selon la revendication 4, dans lequel chacune desdites languettes de retenue est munie d'une encoche médiane, et chacun desdits orifices d'agrafe respectivement sur lesdites pièces femelles formant une petite plaque de guidage légèrement plus étroite que la largeur de ladite encoche médiane.

6. Dispositif de rayonnement de chaleur et de protection pour une barrette de mémoire selon la revendication 1, dans lequel lesdites plaques de rayonnement de chaleur sont fabriquées en matériau de conductivité thermique élevée.

7. Dispositif de rayonnement de chaleur et de protection pour une barrette de mémoire selon la revendication 1, incluant en outre au moins une agrafe en forme de U ayant deux parois extérieures pour agrafer des pattes souples desdites plaques de rayonnement de chaleur combinées.

8. Dispositif de rayonnement de chaleur et de protection pour une barrette de mémoire selon la revendication 7, dans lequel les positions sur lesdites plaques de rayonnement de chaleur sur lesquelles lesdites pattes de ladite agrafe en forme de U sont fixées sont respectivement munies de rainures pour un meilleur engagement entre ladite agrafe en forme de U et lesdites plaques de rayonnement de chaleur.

9. Dispositif de rayonnement de chaleur et de protection pour une barrette de mémoire selon la revendication 8, dans lequel une projection en pointe est formée en poinçonnant chacune des plaques de rayonnement de chaleur, et une dépression en pointe est formée en poinçonnant une paroi intérieure de chacune desdites pattes de ladite agrafe en forme de U, ce qui améliore l'engagement entre ladite agrafe en forme de U et lesdites plaques de rayonnement de chaleur.

10. Dispositif de rayonnement de chaleur et de protection pour une barrette de mémoire selon la revendication 7, dans lequel les deux côtés latéraux proches de chacun des bords inférieurs desdites pattes de ladite agrafe en forme de U sont munis de cavités convergeant vers l'intérieur, et une paire de pièces en saillie correspondantes sont formées à l'intérieur de chacune desdites rainures sur lesdites plaques de rayonnement de chaleur, pour améliorer l'engagement entre ladite agrafe en forme de U et lesdites plaques de rayonnement de chaleur.

11. Dispositif de rayonnement de chaleur et de protection pour une barrette de mémoire selon la revendication 7, dans lequel les bords les plus bas desdites pattes de ladite agrafe en forme de U sont respectivement munis de sections en saillie médianes destinées à former des espaces entre ladite agrafe en forme de U et lesdites plaques de rayonnement de chaleur.

12. Dispositif de rayonnement de chaleur et de protection pour une barrette de mémoire selon la revendication 1, dans lequel une partie de rayonnement de chaleur part d'un bord supérieur desdites plaques de rayonnement de chaleur et dépasse également par le dessus ladite barrette de mémoire.

13. Dispositif de rayonnement de chaleur et de protection pour une barrette de mémoire selon la revendication 12, dans lequel ladite partie de rayonnement de chaleur inclut en outre un engagement mutuel des pièces femelles et mâles.

14. Dispositif de rayonnement de chaleur et de protection pour une barrette de mémoire selon la revendication 12, dans lequel ladite partie de rayonnement de chaleur inclut en outre des plaques en saillie pour empêcher lesdites pièces femelles et mâles engagées de tomber.

15. Dispositif de rayonnement de chaleur et de protection pour une barrette de mémoire selon la revendication 12, dans lequel lesdites plaques de rayonnement de chaleur sont fixées par une paire d'agrafes.

16. Dispositif de rayonnement de chaleur et de protection pour une barrette de mémoire selon la revendication 1 ou 12, dans lequel lesdites pellicules fixées sur lesdites parois intérieures desdites plaques de rayonnement de chaleur sont également fixées sur ladite barrette de mémoire et réalisées en matériau amortisseur et très conducteur de chaleur.

17. Dispositif de rayonnement de chaleur et de protection pour une barrette de mémoire selon la revendication 12, dans lequel ladite partie de rayonnement de chaleur est munie d'une multitude d'ailettes pour agrandir la surface de contact entre lesdites plaques de rayonnement de chaleur et l'air.

18. Dispositif de rayonnement de chaleur et de protection pour une barrette de mémoire selon la revendication 17, dans lequel lesdites ailettes sur ladite partie de rayonnement de chaleur sont formées par poinçonnage et forment sur celle-ci des orifices de passage par paires.

19. Dispositif de rayonnement de chaleur et de protection pour une barrette de mémoire selon la revendication 17, dans lequel lesdites ailettes prennent la forme choisie parmi un rectangle allongé et une forme en demi-cercle ; lesdites ailettes étant disposées en rangées.

20. Dispositif de rayonnement de chaleur et de protection pour une barrette de mémoire selon la revendication 12, dans lequel ladite partie de rayonnement de chaleur est une partie partant vers le haut desdites plaques de rayonnement de chaleur ; des orifices carrés étant formés entre ladite partie de rayonnement de chaleur et lesdites plaques de rayonnement de chaleur pour l'insertion desdites agrafes.

21. Dispositif de rayonnement de chaleur et de protection pour une barrette de mémoire selon la revendication 12, dans lequel ladite partie de rayonnement de chaleur est un composant détachable desdites plaques de rayonnement de chaleur.

22. Dispositif de rayonnement de chaleur et de protection pour une barrette de mémoire selon la revendication 16, dans lequel ladite couche est choisie parmi une matière plastique, un matériau en mousse ou un matériau au silicium.
